Europäisches Patentamt

European Patent Office

Office européen des brevets

(11) Veröffentlichungsnummer: **0 073 003**
A2

## (12) EUROPÄISCHE PATENTANMELDUNG

(21) Anmeldenummer: **82107476.2**

(22) Anmeldetag: **17.08.82**

(51) Int. Cl.³: **G 06 F 1/04**
**H 03 K 3/03**

(30) Priorität: **26.08.81 DE 3133682**

(43) Veröffentlichungstag der Anmeldung:
**02.03.83 Patentblatt 83/9**

(84) Benannte Vertragsstaaten:
**AT BE CH DE FR GB IT LI LU NL SE**

(71) Anmelder: **Müller, Otto**
**Am Guckenbühl 10**
**D-7750 Konstanz 16(DE)**

(72) Erfinder: **Müller, Otto**
**Am Guckenbühl 10**
**D-7750 Konstanz 16(DE)**

(74) Vertreter: **Riebling, Günter Dr.-Ing., Dipl.-Ing.,**
**Ing.grad. et al,**
**Rennerle 10**
**D-8990 Lindau(DE)**

(54) **Zentraleinheit eines digitalen Rechensystems mit asynchroner Taktschaltung.**

(57) Die Taktschaltung für die Zentraleinheit eines digitalen Rechensystems besteht aus zwei im wesentlichen identischen Schaltungsteilen 1,2, von denen jeder Schaltungsteil aus der Serienschaltung von drei NAND-Gattern 30, 32, 26 oder 27, 33, 34 besteht. Die Taktschalung ist asynchron, d.h., durch Zuführung entsprechender Signale ($\overline{SLW}$ oder $\overline{DLY}$) kann die Periodendauer verändert oder die Schwingung angehalten werden.

EP 0 073 003 A2

./...

FIG 1

1/20073003

---------------------------------------------------------------

Zentraleinheit eines digitalen Rechensystems mit
asynchroner Taktschaltung

---------------------------------------------------------------

Gegenstand der Erfindung ist eine Zentraleinheit eines
digitalen Rechensystems mit asynchroner Taktschaltung,
bei der ein Flip-Flop und zwei zugeordnete Verzögerungsglieder im Gegentakt geschaltet sind.

Bei der Verwendung von Taktschaltung für Zentraleinheiten
bei digitalen Rechensystemen ist es erforderlich,
daß die Taktschaltung asynchron arbeitet, d.h., durch
von aussen an die Taktschaltung anlegbare Signale
muß die Periodendauer veränderbar sein. Auf diese
Weise ist es möglich, eine Abstimmung zwischen der
Zentraleinheit (CPU) und einem Speicher zu erzielen.
Hat der Speicher während einer Zykluszeit seinen Lese-
oder Schreibvorgang noch nicht beendet, dann hält er
einfach die Taktschaltung an und verlängert so den
Rechentakt, so daß keine Kollisionen zwischen der
Zentraleinheit und dem Speicher vorkommen können
(asynchroner Betrieb).

Bei den bisher bekannten asynchronen Taktschaltungen
bestand jedoch der Nachteil, daß durch von aussen auf
die Taktschaltung einwirkende Störspannungenspitzen
die Taktschaltung unbeabsichtigt zum Stehen kommen
konnte und die Zentraleinheit dann ausfällt. Die
bekannten asynchronen Taktschaltungen bestehen aus
einer Reihe von hintereinandergeschalteten Verzögerungsgliedern, und diese Kettenschaltungen haben immer einen
Zustand, wo sich auch kein Puls in der Kette befinden kann, wo sich also ein stabiler Zustand einstellt und die Taktschaltung zum Erlöschen kommt. Ausserdem besteht bei den bekannten Taktschaltungen der Nachteil, daß sich in der Verzögerungskette mehrere Störimpulse einschleichen können; der Oszillator schwingt dann mit höherer Frequenz, was ebenfalls unerwünscht ist.

Die vorliegende Erfindung hat sich gegenüber Taktschaltungen gemäss dem Oberbegriff des Anspruches 1 die Aufgabe gestellt, eine Taktschaltung so weiterzubilden, daß nie ein stabiler Zustand erreicht werden kann, d.h., daß ein ständig schwingender Oszillator geschaffen wird, der durch von aussen auf die Taktschaltung einwirkende Störspannungsimpulse nicht zum Erlöschen gebracht werden kann.

Zur Lösung der gestellten Aufgabe ist die Erfindung dadurch gekennzeichnet, daß die Taktschaltung aus zwei im wesentlichen identischen und in Serie geschalteten Schaltungsteilen besteht, von denen jeder Schaltungsteil aus der Serienschaltung von drei NAND-Gattern besteht, wobei der Ausgang des letzten Gatters auf den Eingang des ersten Gatters zurückgekoppelt ist und der eine Eingang des letzten Gatters des einen Schaltungsteiles mit dem Ausgang des ersten Gatters des anderen Schaltungsteiles verbunden ist und daß die Verzögerungsglieder aus einer RC-Kombination bestehen, von denen der eine Pol des R-Gliedes auf dem Potential der Versorgungsspannung und der andere Pol am Eingang des zweiten bzw. dritten Gatters anliegt, an dem der eine Pol des C-Gliedes anliegt, dessen anderer Pol auf Massepotential liegt.

Wesentliches Merkmal bei der vorliegenden Erfindung ist also, daß ein selbstschwingender Oszillator hoher Stabilität geschaffen wird, der unempfindlich gegen eintreffende Störspannungsspitzen ist. Die erfindungsgemässe Schaltung enthält ein aus NAND-Gattern aufgebautes Flip-Flop, dessen beide Flip-Flop-Seiten symmetrisch ausgebildet sind und mit entsprechenden Verzögerungsgliedern beschaltet sind. Aufgrund der Ausbildung der Taktschaltung aus zwei im wesentlichen identischen und in Serie geschalteten Schaltungsteilen besteht der Vorteil, daß jeder Flip-Flop-Teil jedes Schaltungsteiles mit einer gewissen Verzögerung Löschimpulse auf die Flip-Flop-Seite des anderen Schaltungsteiles bringt und dies umschaltet. Da diese Löschimpulse symmetrisch auf beiden Schaltungsseiten erzeugt werden, wird das Flip-Flop von jedem Schaltungsteil abwechselnd nach der jeweiligen Verzögerungszeit über die Löschimpulse umgesetzt.

Die Schaltung hat dadurch keinen stabilen Zustand, wo der Oszillator nicht schwingt. Die Schwingung dieser Schaltung kann vor allem nicht durch irgendwelche Störimpulse zum Erlöschen gebracht werden.

In einer Weiterbildung der vorliegenden Erfindung ist es nach dem Gegenstand des Anspruches 3 vorgesehen, daß die Periodendauer der Taktschaltung durch von außen anlegbare digitale Signale steuerbar ist. Hierdurch ergibt sich die Möglichkeit des Einsatzes einer solchen Schaltung für den asynchronen Betrieb. Der Oszillator kann damit von dem an die CPU angeschlossenen Speicher angehalten werden (Signal $\overline{DLY}$) oder auch verlangsamt werden (Signal $\overline{SLW}$). Das Anhalten des Oszillators durch den Speicher hat den Vorteil, daß der Speicher sich seine Zykluszeit selbst bestimmen kann und damit die CPU auf den Speicher warten kann.

Wesentliches Merkmal hierbei ist, daß, wenn die Taktschaltung durch das digitale Signal gestoppt wird, sie sofort weiterläuft, wenn das digitale Signal seinen Zustand ändert. Diese Schaltung fällt also nicht in einen stabilen Zustand und bedarf des Anstosses von aussen.

Die beiden im Kennzeichen des Anspruches 1 definierten RC-Glieder definieren die Verzögerungszeit des jeweiligen Schaltungsteiles. Diese Verzögerungsglieder bewirken, daß ein Flip-Flop-Ausgang nie länger als die Verzögerungszeit in einem bestimmten digitalen Zustand verharren kann, d.h., beide Schaltungsteile schwingen mit genau gleicher Periodendauer, wenn die Verzögerungsglieder gleich dimensioniert sind.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen offenbarten Angaben und Merkmale, insbesondere die in den Zeichnungen dargestellte räumliche Ausbildung werden als erfindungswesentlich beansprucht, soweit sie einzeln oder in Kombination gegenüber dem Stand der Technik neu sind.

Im folgenden wird die Erfindung an Hand einer lediglich einen Ausführungsweg darstellenden Zeichnung näher erläutert. Hierbei gehen aus der Zeichnung und ihrer Beschreibung weitere erfindungswesentliche Merkmale und Vorteile der Erfindung hervor.

Es zeigen:

Fig. 1: Schaltbild einer Taktschaltung nach der Erfindung,

Figuren 2a bis 2f : Signalverläufe an den Ausgängen der
            Gatter 27,33, 34, 36, 30 und 32.

Hinsichtlich der Typenbezeichnungen der einzelnen Gatter (z.B. LS 08 oder S 132 oder S 03) wird darauf hingewiesen, daß es sich hier um genormte Typenbezeichnungen der Firma Texas Instruments handelt, die z.B. aus der Veröffentlichung "The TTL Data Book, 2. Auflage, 1973,: "54/74 Families of comatible TTL circuits" zu entnehmen sind.

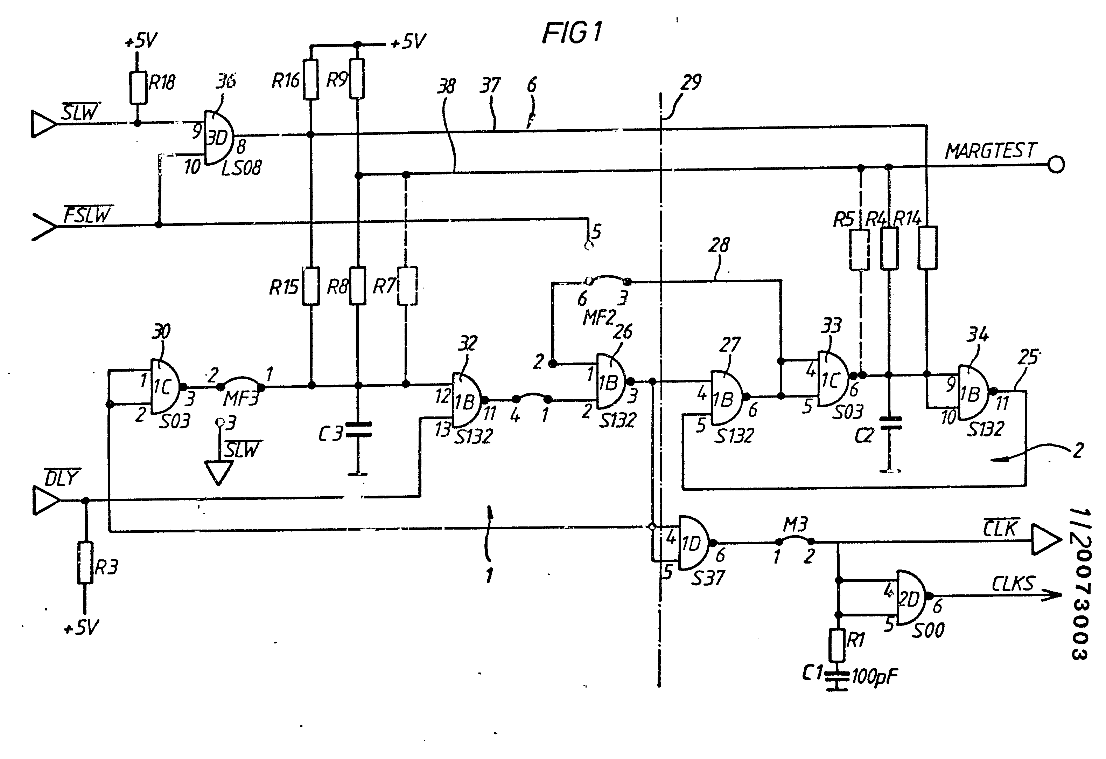

In der in Fig. 1 gezeigten Taktschaltung besteht eine Symmetrielinie 29, hinsichtlich der zwei im wesentlichen identische Schaltungsteile 1 und 2 gezeigt sind.

In der Schaltung wird ein Flip-Flop aus zwei NAND-Gattern 26,27 gebildet. Die Gatter 26,27 sind als Schmitt-Trigger ausgebildet, sie können aber auch einfache NAND-Gatter sein.

Wenn der Eingang 4,5 des Gatters 33 logisch 0 wird, wird der Ausgang 6 logisch 1. Hierdurch wird das RC-Glied, bestehend aus dem Widerstand R14 und dem Kondensator C2, aufgeladen, unter der Voraussetzung, daß an der Leitung 37 eine logische 0 anliegt. Die Ladekurve wird also bestimmt durch die Dimension des RC-Gliedes R14-C2. Die Aufladung erfolgt so lange, bis am Eingang 9,10 des Schmitt-Triggers 34 die Schaltschwelle überschritten wird und der Ausgang 8 low wird. Dieses Signal wird über die Leitung 25 auf den Eingang 5 des Gatters 27 aufgeschaltet, das dann - vorausgesetzt, daß der Eingang 4 das gleiche Potential aufweist - umschaltet und am Ausgang 6 logisch 1 wird.
Der Schwingungsvorgang ist damit beendet.

Das Umschalten des Gatters 27 am Ausgang 6 bewirkt gleichzeitig über die Kreuzungsleitung 28, daß der Eingang 1
am Gatter 26, das als Schmitt-Trigger ausgebildet ist,
logisch 1 wird. Vorausgesetzt, daß der Eingang 2 dieses
Gatters 26 den gleichen Schaltzustand aufweist, wird der
Ausgang 3 des Gatters 26 low und damit der Eingang 4 des
Gatters 27. Das Flip-Flop hält den gespeicherten Schaltzustand so ein sich selbst, unabhängig vom Ladezustand
des RC-Gliedes, wonach, weil das Signal über die Kreuzungsleitung 28 auf den anderen Flip-Flop-Eingang des
Schaltungsteils 1 zurückgekoppelt wurde, der andere
Schaltungsteil 1 einen Schwingungszustand ausführt.

Das Schaltungsteil 1 besteht aus den Gattern 30,32,26,
wobei die Gatter 32,26 als Schmitt-Trigger ausgebildet
sind. Unter der Annahme, daß der Ausgang 3 des
Gatters 30 umschaltet, und zwar von einer logisch 0
auf eine logisch 1, dann folgt dieser Ausgang einer
Ladekurve entsprechend den Dimensionen des RC-Gliedes
C3-R15. Sobald die Schaltschwelle am Eingang 12 des
Gatters 32 überschritten ist und sofern der andere
Eingang 13 auf logisch 1 liegt, schaltet der Ausgang 11
des Gatters 32 auf logisch 0, so daß ein gleicher
Schaltzustand am Eingang 2 des Gatters 26 vorliegt.
Zusammen mit dem Schaltzustand am Eingang 1, der über
die Kreuzungsleitung 28 von dem rechten Schaltungsteil 2
zurückgekoppelt wurde, ergibt sich damit eine Zustandsänderung am Ausgang 3 des Gatters 26, die über die Leitung 35 auf den Eingang 1,2 des Gatters 30 zurückgekoppelt wird. Beide Schaltungsteile 1,2 schwingen sich so gegenseitig an, ohne daß jeweils ein stabiler Zustand erreicht werden kann. Ein Flip-Flop-Ausgang kann deshalb nie länger als die Verzögerungszeit, die durch die Ladekurve des jeweiligen RC-Gliedes gegeben ist, low sein, d.h., beide Schaltungsteile 1,2 schwingen mit genau gleichen Periodendauern, wenn die RC-Glieder gleich dimensioniert sind.

Zusätzlich kann der so gebildete asynchrone Oszillator 6 von aussen in seiner Periodendauer gesteuert werden.

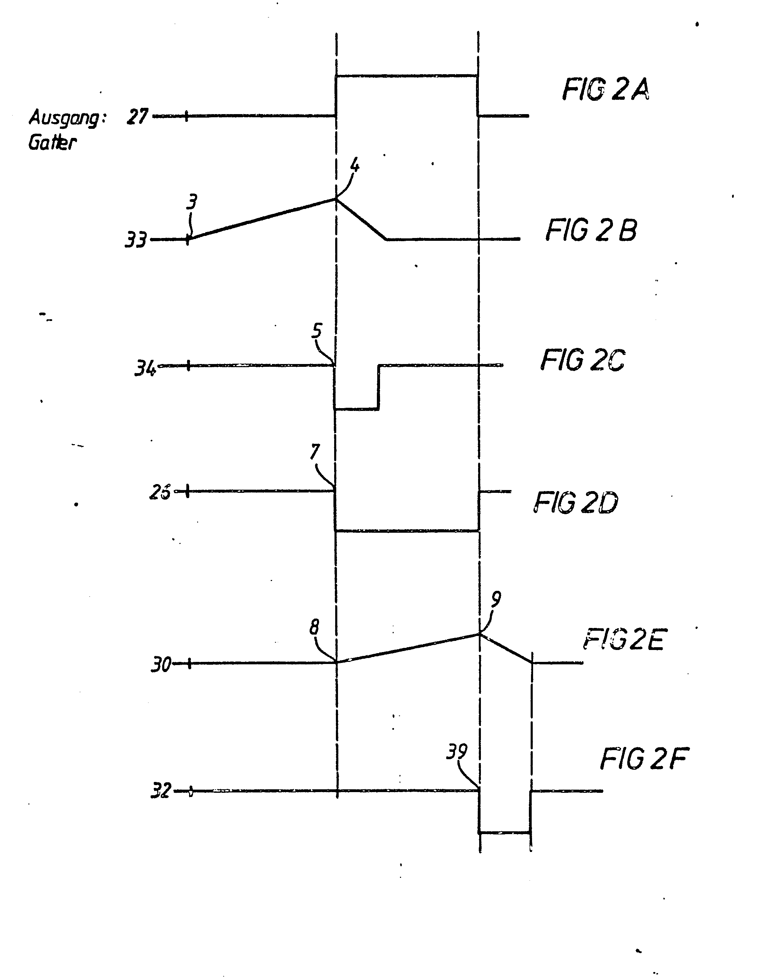

Die Figuren 2a bis 2f zeigen die verschiedenen Schaltzustände an den Ausgängen der jeweiligen Gatter. Geht man davon aus, daß der Ausgang 6 des Gatters 27 von logisch 1 auf logisch 0 umschaltet, dann wird das Gatter 33 entsprechend der Ladekurve des RC-Gliedes C2-R14 vom Punkt 3 ausgehend bis zum Punkt 4 aufgeladen. Der Punkt 4 stellt die Schaltschwelle des nachgeschalteten Schmitt-Triggers 34 dar, so daß das Gatter 34 im Punkt 5 umschaltet und auf logisch 0. Die absteigende Flanke am Ausgang des Gatters 33 wird von dem linken Schaltungsteil 1 gesteuert, so wie es in den Figuren 2d bis 2f dargestellt ist.

Der Schaltzustand am Ausgang des Gatters 27 wird über die Leitung 28 dem Eingang 1 des Gatters 26 zugeführt. Das Gatter 26 geht dabei von high auf low (Punkt 7 in Fig. 2d), und über die Leitung 35 wird dieser Impuls auf den Eingang 1,2 des Gatters 30 gegeben, das damit umschaltet und entsprechend der Ladekurve des RC-Gliedes C3-R15 vom Punkt 8 ausgehend auf den Punkt 9 sich auflädt, bis die Schaltschwelle des nachgeschalteten, als Schmitt-Trigger ausgebildeten Gatters 32 erreicht ist.

Entsprechend wird nach dem Erreichen der Schaltschwelle im Punkt 9 der Ausgang 11 des Gatters 32 umgeschaltet (punkt 39). Die gezeigte Schaltung kann von aussen her sehr einfach in der Periodendauer gesteuert werden. Die Steuerung erfolgt auf zweifache Art.

Zunächst kann man die Dimensionen der RC-Glieder C3-R15 bzw. C2-R14 ändern, indem man weitere Widerstände R9 und R16 zuschaltet. Die Zuschaltung erfolgt aber nur, wenn der Ausgang 8 des Gatters 36 logisch 1 ist.

Der Ausgang des Gatters 36 wird aber nur dann logisch 1, wenn das digitale Signal $\overline{SLW}$ und gleichzeitig das digitale Signal $\overline{FSLW}$ logisch 1 sind. Sobald dieser Schaltzustand vorliegt, wird der Ausgang 8 des Gatters 36 logisch 1 und dem Widerstand R15 ist dann der weitere Widerstand R16 in Serie vorgeschaltet, wodurch die Ladekurve einen langsameren Anstieg einnimmt und die Verzögerungszeit hiermit vergrössert wird.

Ebenso kann das digitale Signal MARGTEST zugeschaltet werden, das, wenn es sich auf logisch 1 befindet, den Widerständen R15, R14 die Widerstände R8 und R4 und wahlweise noch die Widerstände R7 und R5 parallelschaltet. Die Verzögerungszeit wird damit verkürzt und die Schaltung schwingt schneller.

Mit Zuführung des digitalen Signals $\overline{DLY}$ kann der gesamte Schwingungsvorgang angehalten werden, sofern dieses Signal logisch 0 wird. Wichtig hierbei ist, daß die Schaltung sofort weiterschwingt, wenn das $\overline{DLY}$-Signal seinen Zustand wechselt.

PATENTANSPRÜCHE
————————————————————————————————

1. Zentraleinheit eines digitalen Rechensystems mit asynchroner Taktschaltung, bei der ein Flip-Flop mit zwei zugeordneten Eingängen und zwei zugeordnete Verzögerungsglieder im Gegentakt geschaltet sind, d a d u r c h  g e k e n n z e i c h n e t, daß die Taktschaltung (6) aus zwei im wesentlichen identischen und in Serie geschalteten Schaltungsteilen (1,2) besteht, von denen jeder Schaltungsteil (1 oder 2) aus der Serienschaltung von drei NAND-Gattern (30,32,26 oder 27,33,34) besteht, wobei der Ausgang des letzten Gatters (26 oder 34) auf den Eingang des ersten Gatters (30 oder 34) zurückgekoppelt ist und der eine Eingang des letzten Gatters (26) des einen Schaltungsteiles (1) mit dem Ausgang des ersten Gatters (27) des anderen Schaltungsteiles (2) verbunden ist und daß die Verzögerungsglieder aus einer RC-Kombination (C3, R15 oder C2, R14) bestehen, von denen der eine Pol des R-Gliedes (R15 oder R14) auf dem Potential der Versorgungsspannung und der andere Pol am Eingang des zweiten bzw. dritten Gatters (32 bzw. 34) anliegt, an dem der eine Pol des C-Gliedes (C3 oder C2) anliegt, dessen anderer Pol auf Massepotential liegt.

2. Zentraleinheit nach Anspruch 1, d a d u r c h  g e k e n n z e i c h n e t, daß das zweite und dritte Gatter (32 und 26) des einen Schaltungsteiles (1) sowie das erste und dritte Gatter (27 und 34) des anderen Schaltungsteiles (2) als Schmitt-Trigger ausgebildet sind.

3. Zentraleinheit nach Anspruch 1 oder 2, d a d u r c h  g e k e n n z e i c h n e t, daß die Schwingung der Taktschaltung (6) dadurch gestoppt werden kann, daß an einen zweiten Eingang des zweiten Gatters (32) des ersten Schaltungsteiles (1) ein digitales Signal (DLY) anlegbar ist.

4. Zentraleinheit nach einem der Ansprüche 1 bis 3, d a d u r c h   g e k e n n z e i c h n e t, daß die Periodendauer der Taktschaltung (6) dadurch steuerbar ist, daß der nicht am Eingang des Gatters (32 oder 34) liegende Pol des R-Gliedes (R14 oder R15) an den Ausgang eines Gatters (36) der Versorgungsspannung anliegt und an dessen Eingang ein digitales Signal (SLW) zur Steuerung der Periodendauer anlegbar ist.

5. Zentraleinheit nach einem der Ansprüche 1 bis 3, d a d u r c h   g e k e n n z e i c h n e t , daß die Periodendauer der Taktschaltung (6) dadurch steuerbar ist, daß den Widerständen (R14, R15) der RC-Kombination (C3-R15 und C2-R14) ein weiterer Widerstand (R8 oder R4) parallel geschaltet ist, der jeweils mit seinem freien Pol an ein digitales Signal (MARG TEST) und über einen Widerstand (R9) an die Versorgungsspannung angelegt ist.

FIG 1

0073003

212

FIG 2A

Ausgang: 27
Gatter

4

3

33 FIG 2 B

5

34 FIG 2C

7

25 FIG 2D

9

8 FIG2E

30

39 FIG 2F

32